Europäisches Patentamt

European Patent Office

Office européen des brevets

(19)

(11) EP 0 429 715 B1

(12) **EUROPÄISCHE PATENTSCHRIFT**

(45) Veröffentlichungstag und Bekanntmachung des Hinweises auf die Patenterteilung:
**10.07.1996 Patentblatt 1996/28**

(51) Int Cl.$^6$: **G01R 33/38**, G01R 33/56

(21) Anmeldenummer: **89122188.9**

(22) Anmeldetag: **01.12.1989**

(54) **Verfahren zum Betrieb eines Kernspintomographiegeräts mit einem Resonanzkreis zur Erzeugung von Gradientenfeldern**

Method of operating a nuclear spin tomograph apparatus with a resonant circuit for producing gradient fields

Procédé pour la mise en oeuvre d'un appareil de tomographie à spin nucléaire avec un circuit résonant pour la production de gradients de champs

(84) Benannte Vertragsstaaten:
**DE GB**

(43) Veröffentlichungstag der Anmeldung:
**05.06.1991 Patentblatt 1991/23**

(60) Teilanmeldung: **96100084.1**

(73) Patentinhaber: **SIEMENS AKTIENGESELLSCHAFT 80333 München (DE)**

(72) Erfinder:
- **Nowak, Stefan, Dipl.-Ing. (FH)**
  **D-8520 Erlangen (DE)**
- **Schmitt, Franz, Dipl.-Phys.**
  **D-8523 Baiersdorf (DE)**
- **Fischer, Hubertus, Dipl.-Phys.**
  **D-8520 Erlangen (DE)**

(56) Entgegenhaltungen:
DE-A- 3 415 041    DE-A- 3 643 577
DE-A- 3 902 479    US-A- 4 628 264

- **SOCIETE OF MAGNETIC RESONANCE IN MEDICINE, SEVENTH ANNUAL MEETING AND EXHIBITION, BOOKS OF ABSTRACTS, San Francisco, CA, 20.-26. August 1988, Band 2, Seite 1013; J.H. KIM et al.: "Whole body NMR spiral-scan echo planar imaging (SEPI) using resonant gradient coil"**
- **JOURNAL OF PHYSICS E: SCIENTIFIC INSTRUMENTS, Band 15, 1982, Seiten 74-79, London, GB; G. JOHNSON et al.: "Instrumentation for NMR spin-warp imaging"**
- **JOURNAL OF PHYSICS E: SCIENTIFIC INSTRUMENTS, Band 13, 1980, Seiten 947-955, London, GB; J.M.S. HUTCHISON et al.: "A whole-body NMR imaging machine"**

**Beschreibung**

Die Erfindung betrifft ein Verfahren zum Betrieb eines Kernspintomographiegeräts mit einer Pulssequenz, bei der je Scan nach einer Anregung eine Auslesesequenz folgt, bei der mindestens zwei senkrecht aufeinander stehende Gradienten zur Ortskodierung eingeschaltet werden, wobei die entstehenden Signale digitalisiert und im K-Raum in eine Rohdatenmatrix eingeschrieben werden, wobei aus der Rohdatenmatrix durch eine mindestens zweidimensionalen Fouriertransformation ein Bild gewonnen wird, wobei mindestens eine Gradientenspule mit mindestens einem Kondensator zu einem Resonanzkreis zusammengeschaltet ist, der an einen Gradientenverstarker angeschlossen ist, wobei der Gradientenverstärker nach einer vorbestimmten Zeitfunktion angesteuert wird.

Ein derartiges Verfahren ist aus dem Dokument EP 0 227 411 bekannt. Dabei werden durch Verwendung eines Parallelresonanzkreises zur Erzeugung von Gradientenpulsen die ansonsten bei schnellen Pulssequenzen extrem hohen Leistungsanforderungen an den Gradientenverstärker vermindert. Vor Beginn einer Pulssequenz wird der Kondensator durch eine Hilfsspannungsquelle $V_2$ aufgeladen, die einen Teil der benötigten Spitzenspannung aufbringt. Der restliche Teil wird ausgehend von einer - z.B. mittels einer Hilfsspannungsquelle $V_1$-stromgeladenen Schwingkreisspule durch Resonanzbetrieb vor Beginn der eigentlichen Sequenz aufgebracht. Die im Kondensator gespeicherte Energie wird nötigenfalls mittels einer weiteren Hilfsspannungsquelle $V_3$ aufrechterhalten.

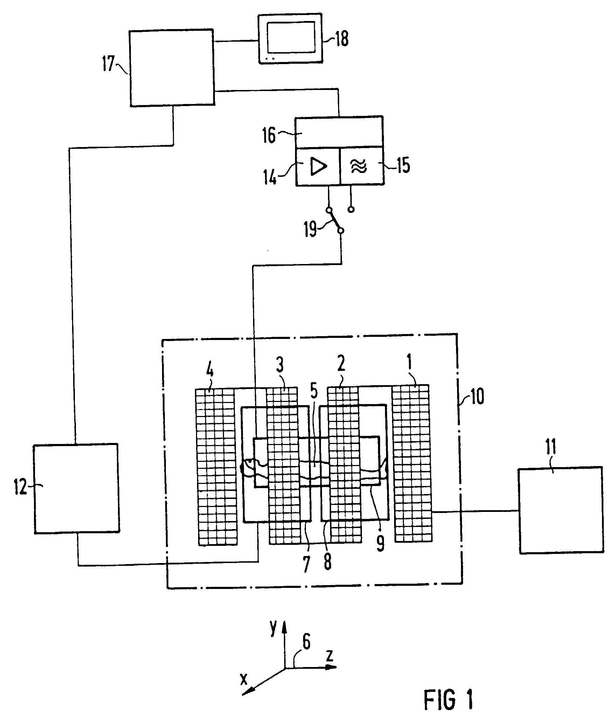

Zur Erläuterung der Problemstellung sind in FIG 1 die Grundkomponenten eines Kernspintomographiegerätes schematisch dargestellt. Die Spulen 1 bis 4 erzeugen ein magnetisches Grundfeld B0, in welchem sich bei Anwendung zur medizinischen Diagnostik der zu untersuchende Körper eines Patienten 5 befindet. Diesem sind außerdem Gradientenspulen zugeordnet, die zur Erzeugung unabhängiger, zueinander senkrechter Magnetfeldkomponenten der Richtungen x, y und z gemäß dem Koordinatenkreuz 6 vorgesehen sind. In der FIG 1 sind der Übersichtlichkeit halber nur die Gradientenspulen 7 und 8 gezeichnet, die zusammen mit einem Paar gegenüberliegender, gleichartiger Gradientenspulen zur Erzeugung eines x-Gradienten dienen. Die gleichartigen, nicht eingezeichneten y-Gradientenspulen liegen parallel zum Körper 5 und oberhalb sowie unterhalb von ihm, die für das z-Gradientenfeld quer zu seiner Längsachse am Kopf- und am Fußende.

Die Anordnung enthält außerdem noch eine zur Erzeugung und Aufnahme der Kernresonanzsignale dienende Antenne 9. Die von einer strichpunktierten Linie 10 umgrenzten Spulen 1, 2, 3, 4, 7, 8 und 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Hochfrequenzspule 9 ist über einen Signalverstärker 14 bzw. einen Hochfrequenzsender 15 an einen Prozeßrechner 17 gekoppelt, an den zur Ausgabe der Abbildung ein Bildschirmgerät 18 angeschlossen ist. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

Für die Ansteuerung der Hochfrequenzeinrichtung 16 und der Gradientenspulen sind eine Reihe von Pulssequenzen bekannt. Dabei haben sich Verfahren durchgesetzt, bei denen die Bilderzeugung auf einer zwei- bzw. dreidimensionalen Fourier-transformation beruht. Die erfindungsgemäße Schaltung läßt sich besonders vorteilhaft beim bekannten Echoplanar(EPI)Verfahren einsetzen. Das Prinzip der Bilderzeugung nach dem EPI-Verfahren wird im folgenden anhand der FIG 2 bis 8 kurz erläutert. Eine detaillierte Beschreibung findet sich in der EP-B1-0 076 054.

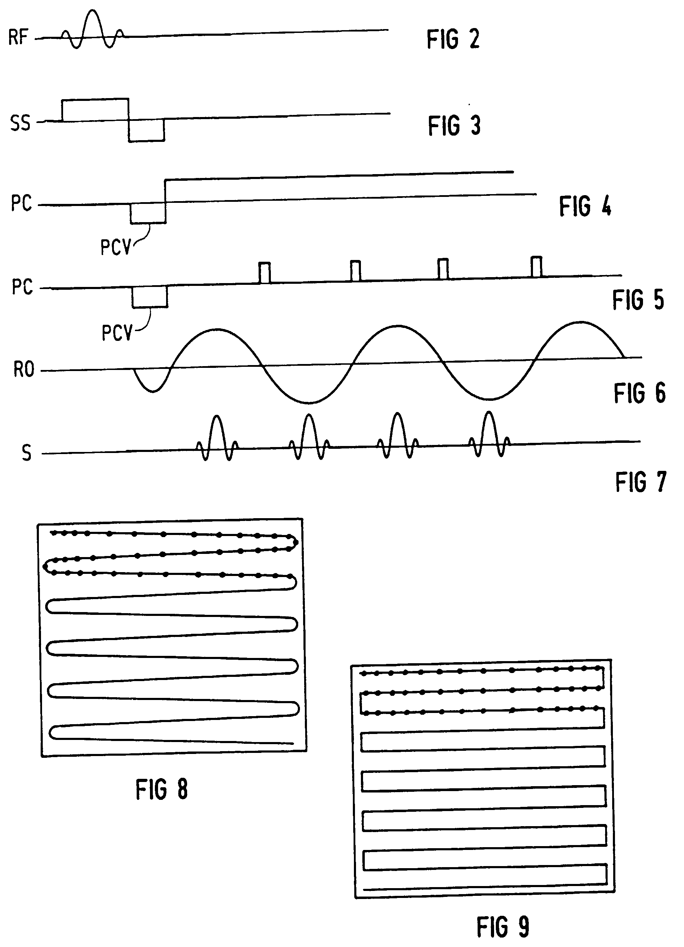

Die FIG 2 bis 7 stellen ein Beispiel für eine beim EPI-Verfahren angewandte Pulssequenz dar. Ein HF-Anregungspuls RF wird zusammen mit einem Gradienten SS in z-Richtung auf das Untersuchungsobjekt eingestrahlt. Damit werden Kernspins in einer Schicht des Untersuchungsobjektes angeregt. Anschließend wird die Richtung des Gradienten SS invertiert, wobei der negative Gradient SS die durch den positiven Gradienten SS verursachte Dephasierung der Kernspins rückgängig macht.

Nach der Anregung wird ein Phasenkodiergradient PC und ein Auslesegradient RO eingeschaltet. Für den Verlauf dieser beiden Gradienten gibt es verschiedene Möglichkeiten. FIG 4 zeigt als erstes Beispiel einen Phasenkodiergradienten PC, der während der Auslesephase kontinuierlich eingeschaltet bleibt. FIG 5 zeigt als Alternative dazu einen Phasenkodiergradienten PC, der aus kurzen Einzelimpulsen ("blips") besteht, die bei jedem Polaritätswechsel des Auslesegradienten RO eingeschaltet werden. Den Phasenkodiergradienten PC geht jeweils ein Vorphasiergradient PCV in negativer Phasenkodierrichtung voraus. Der Ausleseegradient RO wird mit ständig wechselnder Polarität eingeschaltet, wodurch die Kernspins im Wechsel dephasiert und wieder rephasiert werden, so daß eine Folge von Signalen S entsteht. Dabei werden nach einer einzelnen Anregung so viele Signale gewonnen, daß der gesamte Fourier-K-Raum abgetastet wird, d.h. daß die vorliegende Information zur Rekonstruktion eines vollständigen Schnittbildes ausreicht. Hierzu ist eine extrem schnelle Umschaltung des Auslesegradienten RO mit hoher Amplitude erforderlich, die mit den sonst bei der MR-Bildgebung üblicherweise angewandten Rechteckimpulsen kaum realisiert werden kann. Einige gebräuchliche Lösung dieses Problems besteht darin, die den Auslesegradienten RO erzeugende Gradientenspule in einem Resonanzkreis zu betreiben, so daß der Auslesegradient RO eine Sinusform aufweist.

Die entstehenden Kernresonanzsignale S werden im Zeitbereich abgetastet, digitalisiert und die so gewonnenen numerischen Werte in eine Rohdatenmatrix eingetragen. Die Rohdatenmatrix kann man als Meßdatenraum, bei dem im Ausführungsbeispiel vorliegenden zweidimensionalen Fall als Meßdatenebene betrachten. Dieser Meßdatenraum wird in der Kernspintomographie als K-Raum bezeichnet. Die Lage der Meßdaten im K-Raum ist in FIG 8 für einen Phasenkodiergradienten PC nach FIG 4, in FIG 9 für einen Phasenkodiergradienten PC nach FIG 5 schematisch dargestellt.

Die für die Bilderzeugung notwendige Information über die räumliche Herkunft der Signalbeiträge ist in den Phasenfaktoren kodiert, wobei zwischen dem Ortsraum (also dem Bild) und dem K-Raum mathematisch der Zusammenhang über eine zweidimensionale Fourier-Transformation besteht. Es gilt:

$$S(k_x, k_y) = \iint \rho\,(x, y)\, e^{i(k_x x + k_y y)}\, dx\, dy$$

Dabei gelten folgende Definitionen:

$$k_x(t) = \gamma \int_0^t G_x(t')\, dt'\ ;$$

$$k_y(t) = \gamma \int_0^t G_y(t')\, dt'\ ;$$

$\gamma$ = gyromagnetisches Verhältnis
$\rho$ = Kernspindichte
$G_x$ = Wert des Auslesegradienten RO
$G_y$ = Wert des Phasenkodiergradienten PC.

Beim EPI-Verfahren sind sehr hohe Gradientenamplituden zur Ortskodierung der NMR-Signale notwendig. Diese hohen Gradientenamplituden müssen in kurzen Zeitabständen (< 1 ms) ein- und ausgeschaltet werden, damit die notwendige Information gewonnen werden kann, bevor das Kernresonanzsignal abklingt. Wegen der Induktivität und des Widerstands der Gradientenspulen lassen sich diese Anforderungen mit einer direkt an einen Gradientenverstärker angeschlossenen Gradientenspule in der Praxis nicht erfüllen. Es wären Anschlußleistungen von ca. 5 MW erforderlich.

Dieses Problem läßt sich dadurch lösen, daß die Gradientenspule mit einem Kondensator zu einem Resonanzkreis zusammengeschaltet wird. In der eingangs genannten EP-A1-0 227 411 und in dem US-Patent 4,628,264 sind Schaltungen beschrieben, bei denen die Gradientenspule in einem Parallelresonanzkreis betrieben wird. Um parasitäre Einschwingvorgänge möglichst kurz zu machen, wird dabei der Resonanzkondensator schon vor der eigentlichen Meßsequenz auf die erforderliche Spannung aufgeladen. Nach Zuschalten der felderzeugenden Gradientenspule schwingt dann der Parallelresonanzkreis sofort mit der über den zugeordneten Kondensator eingestellten Resonanzfrequenz.

Dadurch gibt es praktisch keinen Einschwingvorgang mehr.

In der DE-A-34 15 041 A1 wird eine Stromquelle für eine Gradientenspule beschrieben, bei der Kondensatoren zur Energiespeicherung vorgesehen sind, die nach Bedarf über Schalter in Serie mit der Gradientenspule verbindbar sind. Diese Schaltung wird jedoch nicht als echter Resonanzkreis betrieben.

In der Literaturstelle "Society of Magnetic Resonance in Medicine", 7th Annual Meeting, Books of Abstracts, San Francisco, 20.-26. August 1988, Band 2, Seite 1013, ist ein Serienschwingkreis zur Erzeugung von Gradientenströmen für das SEPI-Verfahren dargestellt. Wie der Serienschwingkreis zum Schwingen gebracht wird, ist nicht angegeben.

In der DE-A-39 02 479 ist eine Vorrichtung beschrieben, bei der separate Gradientenspulen für einen linearen und einen resonanten Betrieb vorgesehen sind. Dabei ist angegeben, daß die Gradientenspulen für den resonanten Betrieb in Serie oder parallel zu einem Kondensator geschaltet werden können.

In der älteren EP-A-0 389 666, die Stand der Technik nach Art. 54 (3) EPÜ darstellt, wird eine Gradientenspule in einem Serienresonanzkreis betrieben. Dabei wird der Einschwingvorgang so gewählt, daß das Strom-Integral vom Zeitpunkt des Einschaltens (t = t0) bis zu einem bestimmten Zeitpunkt (t = t1) gerade Null wird.

Damit wird der Kondensator des Serienschwingkreises auf die notwendige Spannung aufgeladen, ohne daß der Gradientenverstärker diese hohe Spannung liefern muß.

Der Nachteil dieses Verfahrens besteht in der relativ langen Einschwingzeit, die durch Induktivität und Widerstand sowie die Ausgangsspannung des Gradientenverstärkers bedingt ist. Da der Einschwingvorgang mit der relativ hohen Betriebsfrequenz erfolgt, weist auch der frequenzabhängige Widerstand der Gradientenspule einen hohen Wert auf, was die Einschwingzeit wesentlich erhöht.

Aufgabe der Erfindung ist es, ein Verfahren zum Betrieb eines Kernspintomographiegeräts der eingangs genannten Art so auszugestalten, daß die Spannungsbelastung des Gradientenverstärkers und die Einschwingzeit gering bleiben.

Diese Aufgabe wird erfindungsgemäß dadurch gelöst, daß der Resonanzkreis ein Serienresonanzkreis (20,30) ist, daß der Kondensator (20) mit einem Schalter (27) überbrückt und der Serienschwingkreis direkt an den Gradientenverstärker (12) angeschlossen ist, und daß der Schalter (27) zwischen Anregung und Auslesesequenz solange geschlossen wird, bis die Gradientenspule (30) mit dem erforderlichen Strom aufgeladen ist. Damit wird der Einschwingvorgang zumindest deutlich beschleunigt, d.h. nach der Anregung kann schnell mit dem Auslesen der Echosignale begonnen werden, bevor ein deutlicher Signalverlust durch Relaxation der Kernspins eingetreten ist. Eine derartige Anordnung läßt sich überall dort vorteilhaft einsetzen, wo Gradienten schnell und/oder mit hoher Amplitude geschaltet werden müssen. Die Spannungsbelastung des Gradientenverstärkers wird deutlich geringer als bei Schaltungen mit einem Parallelresonanzkreis.

Durch die Aufladung der Gradientenspule mit Strom kann der Gradientenverstärker auf eine niedrige Spannung ausgelegt werden und es sind keine zusätzlichen Hilfsspannungsquellen erforderlich. Die Gradientenspule weist hierbei im Gegensatz zur Beaufschlagung mit der Arbeitsfrequenz einen niedrigen Widerstandswert auf, so daß die Gradientenspule schnell aufgeladen werden kann.

Vor der Aufladung der Gradientenspule kann vorteilhafterweise ein Vorphasierpuls in Richtung des Auslesegradienten eingeschaltet werden, der so dimensioniert ist, daß das Maximum des Kernresonanzsignales in die Mitte des von der Rohdatenmatrix gebildeten K-Raumes zu liegen kommt. Mit diesem Vorphasierpuls kann die Phasenlage der Kernspins zu Beginn der Signalauslesephase exakt eingestellt werden.

Ein Betrieb bei unterschiedlichen Resonanzfrequenzen ist möglich, indem zur Gradientenspule mehrere Kondensatoren über je einen Schalter in Serie schaltbar sind, so daß der Serienschwingkreis je nach Stellung der Schalter auf unterschiedliche Resonanzfrequenzen einstellbar ist.

Alternativ zu dem erfindungsgemäßen Verfahren nach Anspruch 1 kann das Kernspintomographiegerät auf einfache Weise für den Betrieb ohne Resonanzkreis umgestellt werden, indem der dem Kondensator des Serienschwingkreises parallel geschaltete Schalter geschlossen wird. Bei geschlossenem Schalter wird die Gradientenspule - wie dies bei Sequenzen mit weniger schneller Gradientenumschaltung zweckmäßig ist - direkt mit dem Gradientenverstärker verbunden, d.h. nicht mehr in einem Resonanzkreis betrieben.

Ein Ausführungsbeispiel der Erfindung wird nachfolgend anhand der FIG 10 bis 14 näher beschrieben. Dabei zeigen:

FIG 10   einen Serienschwingkreis mit Aufladung der Gradientenspule 30,
FIG 11   den Stromverlauf I(t) durch die Gradientenspule 30,
FIG 12   den Stromverlauf I(t) durch die Gradientenspule 30 mit einem Vorphasierpuls PV,
FIG 13   den Stromverlauf I(t) durch die Gradientenspule 30 mit einem Vorphasierpuls PV bei einer nachfolgenden Inversion der Kernspins durch einen 180°-Puls,
FIG 14   eine Schaltungsanordnung, bei der die Resonanzfrequenz umschaltbar ist,

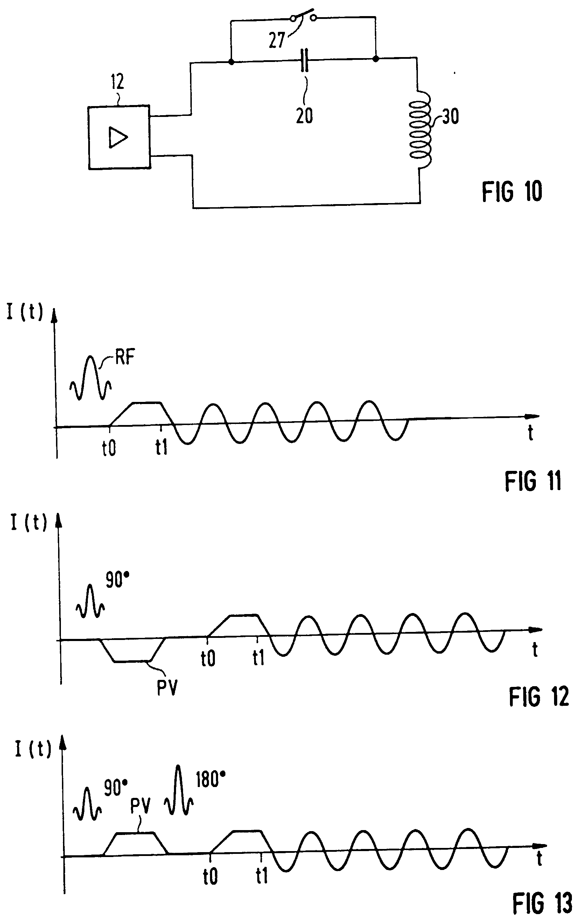

Bei der Schaltungsanordnung nach FIG 10 ist der aus einem Kondensator 20 und einer Gradientenspule 30 gebildete Serienresonanzkreis an den Gradientenverstärker 12 angeschlossen und der Kondensator mit einem Schalter 27 überbrückt. Im folgenden Beispiel wird davon ausgegangen, daß die Gradientenspule 30 zur Erzeugung eines Auslesegradienten RO im Rahmen einer EPI-Sequenz eingesetzt wird. Dabei wird der Schalter 27 nach dem HF-Anregungspuls eingeschaltet. Damit wird die Gradientenspule 30 auf die gewünschte Stromstärke auferregt. Anschließend wird der Schalter 27 geöffnet, so daß der Serienschwingkreis sofort in Resonanz schwingt und somit der Auslesegradient wirksam wird.

Der sich bei dieser Schaltung ergebene Stromverlauf I(t) durch die Gradientenspule 30 ist in FIG 11 dargestellt. Der Anregungs-Hochfrequenzpuls RF ist in FIG 11 schematisch dargestellt. Nach dem Anregungs-Hochfrequenzpuls RF wird zum Zeitpunkt t0 der Schalter 27 eingeschaltet und zum Zeitpunkt t1 wieder ausgeschaltet, worauf dann unmittelbar die Ausleseperiode folgt.

Gegenüber herkömmlichen Methoden zum Einschwingen des Serienresonanzkreises ist hier die störende Zeit zwischen dem Anregungspuls und der Auslesesequenz erheblich verkürzt. Dies rührt daher, daß der Widerstand der Gradientenspule vor allem aufgrund des Skin-Effektes stark frequenzabhängig ist und bei der hier vorliegenden niedrigen "Einschaltfrequenz" deutlich geringer ist als bei der relativ hohen Resonanzfrequenz des Serienschwingkreises, z.B. beträgt der ohm'sche Widerstand einer Gradientenspule bei einer Frequenz von 0,25 kHz 0,22$\Omega$, bei 1,25 kHz dagegen 1,32 $\Omega$. Die Induktivität ändert sich mit der Frequenz nur wenig. Typische Schaltzeiten für die dargestellte Anordnung liegen etwa bei einer Millisekunde für den maximalen Strom I0.

Das durch den Einschaltvorgang erzeugte Stromintegral des Gradientenstromes vom Zeitpunkt t = t0 bis zum Ende des Einschaltvorganges t = t1 ist bei der dargestellten Anordnung nicht mehr Null:

$$\int_{t_0}^{t_1} I(t')\,dt' > 0.$$

Dieses Stromintegral, das die Phasenlage der angeregten Kernspins beeinflußt, wird im allgemeinen als "Vorphasierung" bezeichnet. Beim EPI-Verfahren wird im allgemeinen eine definierte Vorphasierung eingestellt. Damit soll folgendes erreicht werden:

Die besten Bildergebnisse erhält man, wenn die Meßwerte mit der höchsten Amplitude in die Mitte des K-Raumes, also der Rohdatenmatrix nach FIG 8 bzw. FIG 9, zu liegen kommen. Dies wird durch eine definierte Vorphasierung in Phasencodier- und Ausleserichtung erzielt.

Zur Erzielung optimaler Bildergebnisse muß die Vorphasierung genau eingestellt werden. Beim Ausführungsbeispiel einer Pulssequenz nach FIG 12 ist daher vor dem Zeitpunkt t0 des Aufladevorganges der Gradientenspule 21 ein Stromimpuls PV zur Vorphasierung eingeschaltet. Durch die Länge bzw. Amplitude dieses Stromimpulses PV kann dann der erforderliche Wert der Vorphasierung genau eingestellt werden.

Bei einer Pulssequenz, bei der die Kernspins mit einem 180°-HFImpuls invertiert werden, wird auch die Wirkung einer vorausgehenden Phasendrehung invertiert. In diesem, in FIG 13 dargestellten Fall muß dementsprechend anstelle eines negativen Stromimpulses PV nach FIG 12 ein positiver Stromimpuls PV eingeschaltet werden, wenn der Stromimpuls PV dem 180°-Hochfrequenz-Impuls vorangestellt ist.

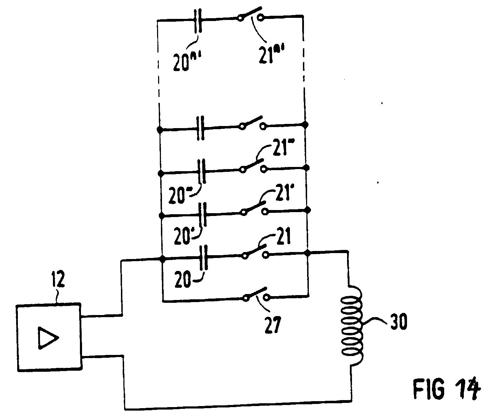

Beim dargestellten Schaltungsbeispiel kann der Serienresonanzkreis auch für mehrere Resonanzfrequenzen ausgelegt sein, indem - wie in FIG 14 dargestellt - mehrere Kondensatoren 20 bis 20n' über Schalter 21 bis 21n' mit der Gradientenspule 30 zu einem Serienschwingkreis zusammenschaltbar sind.

Es ist zu betonen, daß die beschriebene Schaltung nicht nur für Pulssequenzen nach dem in den FIG 2 bis 9 dargestellten EPI-Verfahren vorteilhaft eingesetzt werden kann, sondern überall dort, wo Gradienten schnell und/oder mit hoher Amplitude geschaltet werden müssen.

## Patentansprüche

1. Verfahren zum Betrieb eines Kernspintomographiegeräts mit einer Pulssequenz, bei der je Scan nach einer Anregung eine Auslesesequenz folgt, bei der mindestens zwei senkrecht aufeinander stehende Gradienten (RO, PC) zur Ortskodierung eingeschaltet werden, wobei die entstehenden Signale digitalisiert und im K-Raum in eine Rohdatenmatrix eingeschrieben werden, wobei aus der Rohdatenmatrix durch eine mindestens zweidimensionale Fouriertransformation ein Bild gewonnen wird, wobei mindestens eine Gradientenspule (30) mit mindestens einem Kondensator (20) zu einem Resonanzkreis zusammengeschaltet ist, der an einen Gradientenverstärker (12) angeschlossen ist, wobei der Gradientenverstärker (12) nach einer vorbestimmten Zeitfunktion angesteuert wird, **dadurch gekennzeichnet,** daß der Resonanzkreis ein Serienresonanzkreis (20,30) ist, daß der Kondensator (20) mit einem Schalter (27) überbrückt und der Serienschwingkreis direkt an den Gradientenverstärker (12) angeschlossen ist, und daß der Schalter (27) zwischen Anregung und Auslesesequenz solange geschlossen wird, bis die Gradientenspule (30) mit dem erforderlichen Strom aufgeladen ist.

2. Verfahren nach Anspruch 1, **dadurch gekennzeichnet,** daß vor der Aufladung der Gradientenspule (30) ein Vorphasierpuls (PV) in Richtung des Auslesegradienten (RO) eingeschaltet wird, der so dimensioniert ist, daß das Maximum des Kernresonanzsignales (S) in die Mitte des von der Rohdatenmatrix gebildeten K-Raumes zu liegen kommt.

3. Verfahren nach Anspruch 1 oder 2, **dadurch gekennzeichnet,** daß zur Gradientenspule (30) mehrere Kondensatoren (20 bis 20n') über je einen Schalter (21 bis 21n') in Serie schaltbar sind, so daß der Serienschwingkreis je nach Stellung der Schalter (21 bis 21n') auf unterschiedliche Resonanzfrequenzen einstellbar ist.

4. Verfahren nach einem der Ansprüche 1 bis 3, **dadurch gekennzeichnet,** daß der dem Kondensator (20) des Serienschwingkreises parallel geschaltete Schalter (27) bei Ansteuerung der Gradientenspule (30) ohne Resonanzkreis geschlossen wird.

5. Verfahren nach einem der Ansprüche 1 bis 4, **dadurch gekennzeichnet,** daß eine Pulssequenz nach dem Echoplanar-Verfahren verwendet wird, wobei während der Auslesesequenz ein aus Teilimpulsen mit wechselnder Polarität bestehender Auslesegradient und ein Phasenkodiergradient eingeschaltet werden, wobei je Teilimpuls des Auslesegradienten eine Zeile der Rohdatenmatrix ausgelesen wird und wobei die Gradientenspule (30) des Serienresonanzkreises den Auslesegradienten (RO) erzeugt.

## Claims

1. Method for operating a nuclear spin tomography apparatus with a pulse sequence, in which per scan after an excitation there follows a read-out sequence, in which at least two gradients (RO, PC), which are perpendicular to each other, are generated for location coding, wherein the resultant signals are digitized and are written into a raw data matrix in the K-space, wherein an image is obtained from the raw data matrix by means of at least two-dimensional Fourier transformation, wherein at least one gradient coil (30) is connected together with at least one capacitor (20) to form a resonant circuit which is connected to a gradient amplifier (12), wherein the gradient amplifier (12) is activated after a predetermined time function, characterised in that the resonant circuit is a series resonant circuit (20, 30), in that the capacitor (20) is bridged by a switch (27) and the series resonant circuit is connected directly to the gradient amplifier (12) and in that the switch (27) is closed between excitation and read-out sequence for so long until the gradient coil (30) is charged with the required current.

2. Method according to claim 1, characterised in that before charging the gradient coil (30) there is generated in the direction of the read-out gradient (RO) a pre-phasing pulse (PV) which is dimensioned such that the maximum of the nuclear magnetic resonance signal (S) comes to lie in the centre of the K-space formed by the raw data matrix.

3. Method according to claim 1 or 2, characterised in that a plurality of capacitors (20 to 20n') can be connected in series to the gradient coil (30) by way of a respective switch (21 to 21n') so that 5 the series resonant circuit can be adjusted to different resonant frequencies according to the position of the switches (21 to 21n').

4. Method according to one of the claims 1 to 3, characterised in that the switch (27), which is connected in parallel with the capacitor (20) of the series resonant circuit, is closed in the case of activation of the gradient coil (30) without a resonant circuit.

5. Method according to one of the claims 1 to 4, characterised in that a pulse sequence is used according to the echo planar method, wherein during the read-out sequence a read-out gradient, consisting of partial pulses with changing polarity, and a phase-coding gradient are generated, wherein per partial pulse of the read-out gradient one line of the raw data matrix is read out and wherein the gradient coil (30) of the series resonant circuit generates the read-out gradient (RO).

**Revendications**

1. Procédé pour faire fonctionner un appareil de tomographie à spin nucléaire par une séquence d'impulsions, dans lequel une séquence de lecture suit, à chaque analyse, une excitation, dans lequel on introduit au moins deux gradients (RO, PC) perpendiculaires l'un à l'autre pour le codage d'espace, on numérise les signaux apparaissant et on les enregistre dans l'espace K dans une matrice de données brutes, on obtient une image à partir de la matrice de données brutes par une transformation de Fourier à au moins deux dimensions, au moins une bobine (30) de gradient étant interconnectée avec au moins un condensateur (20) pour former un circuit de résonance, qui est connecté à un amplificateur (12) de gradient, l'amplificateur (12) de gradient pouvant être commandé suivant une fonction temporelle prédéterminée, caractérisé en ce que le circuit de résonance est un circuit (20,30) de résonance série, le condensateur (20) est ponté par un interrupteur (27), le circuit de résonance série est connecté directement à l'amplificateur (12) de gradient et on ferme l'interrupteur (27) entre une excitation et une séquence de lecture, jusqu'à ce que la bobine (30) de gradient soit chargée par le courant nécessaire.

2. Procédé suivant la revendication 1, caractérisé en ce qu'on introduit, avant le chargement de la bobine (30) de gradient, une impulsion (PV) d'avance de phase en direction du gradient (RO) de lecture, cette impulsion (PV) d'avance de phase étant telle que le maximum du signal (S) de résonance nucléaire vienne au milieu de l'espace K formé par la matrice de données brutes.

3. Procédé suivant la revendication 1 ou 2, caractérisé en ce que l'on peut brancher en série avec la bobine (30) de gradient plusieurs condensateurs (20 à 20n') par l'intermédiaire chacun d'un interrupteur (21 à 21n'), de sorte à pouvoir régler le circuit de résonance série sur des fréquences de résonance différentes suivant la position des interrupteurs (21 à 21n').

4. Procédé suivant l'une des revendications 1 à 3, caractérisé en ce que l'on ferme l'interrupteur (27) branché en parallèle avec le condensateur (20) du circuit de résonance série lors de la commande de la bobine (30) de gradient sans circuit de résonance.

5. Procédé suivant l'une des revendications 1 à 4, caractérisé en ce que l'on utilise une séquence d'impulsions suivant le procédé Echoplanar, on introduit, pendant la séquence de lecture, un gradient de lecture constitué d'impulsions partielles de polarité alternant et un gradient de codage de phase, une ligne de la matrice de données brutes étant lue pour chaque impulsion partielle du gradient de lecture et la bobine (30) de gradient du circuit de résonance série produisant le gradient (RO) de lecture.

FIG 1

RF ——— FIG 2

SS ——— FIG 3

PC ——— FIG 4

PCV

PC ——— FIG 5

PCV

RO ——— FIG 6

S ——— FIG 7

FIG 8

FIG 9

FIG 10

FIG 11

FIG 12

FIG 13

FIG 14